## Europäisches Patentamt

## European Patent Office

## Office européen des brevets

(11) Veröffentlichungsnummer: **0 259 813**

**A2**

# (12) EUROPÄISCHE PATENTANMELDUNG

(21) Anmeldenummer: 87113020.9

(22) Anmeldetag: 05.09.87

(51) Int. Cl.4: **C04B 41/83** , H01B 1/12

(30) Priorität: **10.09.86 DE 3630708**

(43) Veröffentlichungstag der Anmeldung:
**16.03.88 Patentblatt 88/11**

(84) Benannte Vertragsstaaten:
**AT BE DE FR GB IT NL**

(71) Anmelder: **BASF Aktiengesellschaft
Carl-Bosch-Strasse 38
D-6700 Ludwigshafen(DE)**

(72) Erfinder: **Naarmann, Herbert, Dr.
Haardtblick 15
D-6719 Wattenheim(DE)**
Erfinder: **Schnoeller, Manfred, Dr.
Grete-Hoffmann-Strasse 24
D-8048 Hainhausen(DE)**
Erfinder: **Wersing, Wolfram
Weidenweg 4
D-8011 Kirchheim(DE)**

(54) **Verfahren zur Herstellung eines Verbundwerkstoffes aus einem elektrisch leitfähigen Polymeren und einem keramischen Werkstoff.**

(57) Verfahren zum Aufbringen einer Schicht aus elektrisch leitfähigen Polymeren auf keramische Werkstoffe, bei dem man auf der Oberfläche des keramischen Werkstoffes Monomere aus der Klasse der fünfgliedrigen Heterocyclen oder Anilin zweckmäßig in Gegenwart eines Leitsalzes polymerisiert.

EP 0 259 813 A2

## Verfahren zur Herstellung eines Verbundwerkstoffes aus einem elektrisch leitfähigen Polymeren und einem keramischen Werkstoff

Die Erfindung betrifft ein Verfahren zum Aufbringen einer Schicht aus elektrisch leitfähigen Polymeren auf keramische Werkstoffe, bei der man auf die Oberfläche des keramischen Werkstoffes Monomere aufbringt und diese polymerisiert.

Nach einer Arbeit von K.C. Khulke und R.S. Mann, Journal of Polymer Science, Vol. 20 (1982), Seiten 1089 bis 1055, kann Pyrrol in wäßriger Lösung unter der Einwirkung von Kaliumpersulfat polymerisiert werden, so daß sich das Polymerisat in Form eines feinteiligen schwarzen Pulvers abscheidet.

Aus der EP-A 133 939 ist ein Verfahren zur elektrochemischen Polymerisation von Pyrrol bekannt, bei dem man Pyrrol in Gegenwart von Leitsalzen in Elektrolytlösungsmitteln durch anodische Oxidation auf einer flächenförmig ausgebildeten Anode polymerisiert, wobei man als Flächenelement Stoffe mit großer Oberfläche, wie Gewebe, Gewirke, Geflechte oder Netze verwendet.

Aufgabe der Erfindung ist es, ein Verfahren zur Herstellung eines Verbundwerkstoffes aus einem elektrisch leitfähigen Polymeren und einem keramischen Werkstoff zu schaffen, das in technisch einfacher Weise durchführbar ist und das eine gute Haftung der Schicht des leitfähigen Polymeren auf dem keramischen Werkstoff bewirkt.

Die Aufgabe der Erfindung wird durch ein Verfahren gelöst, bei dem man auf der Oberfläche des keramischen Werkstoffes ein Monomeres aus der Klasse der fünfgliedrigen Heterocyclen, die Stickstoff oder Schwefel als Heteroatom enthalten oder Anilin aufbringt und durcch chemische oder anodische Oxidation polymerisiert.

Die Polymerisation der Monomeren wird vorteilhaft in Gegenwart von Leitsalzen vorgenommen und als Monomere vorzugsweise Pyrrol oder Thiophen verwendet.

Das Verfahren der Erfindung zum Aufbringen einer leitfähigen Schicht kann auf alle keramischen Werkstoffe angewendet werden. Die Formgebung der Werkstoffe kann beliebig sein. So können die Werkstoffe beispielsweise Dimensionen in einer Richtung haben, die ein vielfaches der Dimensionen quer dazu betragen. So können z.B. die Werkstoffe in Form Stäben, Bändern, Drähten oder Fasern vorliegen. Auch können die Werkstoffe eine zweidimensionale Ausdehnung haben, die ein vielfaches der Dicke des Werkstoffes beträgt, wie Platten oder Scheiben. Mehrschichten-Elemente mit Hohlkörperstrukturen sind ebenfalls geeignet. Ebenso ist es möglich die Schichten auf Werkstoffe beliebiger Formgebung, z.B. solcher wie sie technische Bauteile, Maschinenelemente oder Schaltelemenmte haben, aufzubringen. Die Keramiken können kompakte, glatte Seitenflächen haben oder poröse Strukturen besitzen, mit Poren von 0,0001 bis 100 μ und Dicken von 0,001 bis 5 mm.

Als Werkstoffe, auf die Schichten aus elektrisch leitfähigen Polymeren aufgebracht werden, eignen sich solche keramischen Werkstoffe die beispielsweise Isolatoren sind. Vorzugsweise geeignet sind sogenannte Piezokeramiken auf Basis von Bleizirkonat-titanat mit Dotierungsstoffen wie Neodym, Wismut, Nickel o.ä., geröstet bei Temperaturen bis zu 1400°C.

Die Beschichtung kann durch chemische oder elektrochemische anodische Oxidation erfolgen, z.B. durch Tauchen der Materialien in Lösungen der Monomeren die vorteilhaft ein Leitsalz enthalten.

Zum Ausbilden einer Schicht durch chemische Oxidation der Monomeren bringt man zunächst auf die Oberfläche des Werkstoffs ein Oxidationsmittel auf. Als Oxidationsmittel verwendet man vorteilhaft Sauerstoff enthaltende Oxidationsmittel die, bezogen auf 1 Mol der zu polymerisierenden Verbindung, in Mengen von 0,1 bis 2 Molen Verwendung finden können. Größere Mengen an Oxidationsmittel ist nicht erforderlich, da die Menge ausreicht, den gesamten Ausgangsstoff in Polymere umzuwandeln. Man bringt das Oxidationsmittel zweckmäßig in Lösung auf, wobei sich Wasser als Lösungsmittel gegebenenfalls in Abmischung mit organischen, mit Wasser mischbaren Lösungsmitteln bewährt hat. Es können aber auch organische Lösungsmittel, wie Dimethylsulfoxid, Methanol, Acetonitril,. Ethylencarbonat, Propylencarbonat, Dioxan oder Tetrahydrofuran verwendet werden. Man arbeitet zweckmäßig so, daß die Lösungen 0,1 bis 50 %, vorzugsweise 1 bis 20 Gew.%, des Oxidationsmittels enthalten.

Von den Oxidationsmitteln haben sich insbesondere Peroxosäuren und deren Salze, wie die Peroxodischwefelsäure und deren Alkali-und Ammoniumsalze bewährt, auch Perchlorsäure ist geeignet, sowie deren Schwermetallsalze wie Eisenperchlorat o.ä. Vorzugsweise werden auch Peroxoborate oder Peroxochromate, wie Natriumperborat, Kaliumdichromat oder Eisenperchlorat, verwendet. Außerdem sind Permanganate, wie Kaliumpermanganat geeignet, wenn man diesem Permanganat geringe Mengen Säure zusetzt. Auch ist bevorzugt die Verwendung von Wasserstoffsuperoxid wobei hier die Anwesenheit von Leitsalzen unumgänglich ist.

Nach der Behandlung der Oberfläche des Werkstoffes mit dem Oxidationsmittel und eventuellem Abdampfen des verwendeten Lösungsmittels bringt man nun das zu polymerisierende Monomere auf. Die Monomeren werden ausgewählt aus der Klasse der fünfgliedrigen heterocyclischen Verbindungen, die Stickstoff oder Schwefel als Heteroatom und außerdem ein $\pi$-Elektronensystem konjugierter Verbindungen enthalten oder Anilin.

Beispiele dieser Verbindungen sind solche aus der Klasse der Pyrrole und der Thiophene. Von den Pyrrolen eignen sich z.B. das unsubstituierte Pyrrol selbst aber auch N-substituierte Pyrrole wie N-Alkylpyrrol. Es können aber auch andere substituierte Pyrrole wie 3,4-Dialkylpyrrole oder 3,4-Dichlorpyrrole Verwendung finden. Von den Verbindungen der Klasse der Thiophene eignet sich insbesondere das unsubstituierte Thiophen selbst sowie 2-oder 3-Alkylthiohene, z.B. 2,3-Diethylthiophen. Diese genannten fünfgliedrigen heterocyclischen Verbindungen, wie z.B. Furanen, Thiazol, Oxazol oder Imidazol, polymerisiert werden. Es ist aber auch möglich durch chemische Oxidationsmittel Anilin zu polymerisieren. Eine interessante Variante ist auch das Beschichten des Werkstoffes z.B. mit Polypyrrol.

Man kann die Oxidationsmittel gegebenenfalls zusammen mit einem Leitsalz oder die Monomeren zusammen mit einem Leitsalz auf die Oberfläche des Werkstoffs aufbringen. Die Polymerisation dieser Monomeren kann also in Gegenwart von Leitsalzen erfolgen, die auch als Komplexierungsmittel oder Dotierungsmittel bezeichnet werden. Als Leitsalze haben sich z.B. $KHSO_4$, $C_6H_5\bullet SO_3H$, $H_3COOH$, $LiClO_4$, $NEt_4ClO_4$, $NBu_4ClO_4$, $KAlF_4$, $Na_3AlF_6$, $KBF_4$, $K_2ZrF_6$, $K_2NiF_4$, $CO_2(NO_3)_2$, $H_2SO_4$, $FeCl_3$, $NOPF_6$ oder $NaPF_6$ oder auch Aryl bzw. Alkyl oder Alkarylsulfats bewährt. Die Konzentration der Leitsalze ist so bemessen, daß auf 3 Mol des eingesetzten Monomeren oder der Gemische der Monomeren mindestens 1 Mol der oben aufgeführten Leitsalze verwendet werden; werden beispielsweise $FeCl_3$ oder $Fe(ClO_4)_3$ verwendet, so sind solche Verbindungen Leitsalze oder auch Oxidationsmittel.

Das Aufbringen des Leitsalzes erfolgt zusammen mit dem Oxidationsmittel zweckmäßig in Lösung und Abdampfen des Lösungsmittels oder je nach Art der Aufbringungsart des Monomeren zusammen mit dem Monomeren.

Das Monomere wird besonders vorteilhaft aus der Gasphase auf die mit Oxidationsmittel bzw. mit dem Leitsalz behandelte Oberfläche des Werkstoffs aufgebracht. Dies erfolgt am zweckmäßigsten derart, daß man die behandelten Werkstoffe mit der behandelten Oberfläche in ein Gefäß einbringt, dieses Gefäß evakuiert und mit dem Dampf des Monomeren behandelt.

Man kann das Monomere auch in Lösung auf die mit Oxidations-und Leitmittel behandelte Oberfläche des Werkstoffs aufbringen. Dies erfolgt zweckmäßig derart, daß man Lösungen von Pyrrol oder anderen Heterocyclen oder des Anilins in einem Lösungsmittel aufbringt, die Lösung trocknet und somit die Reaktion des Oxidationsmittels mit dem Monomeren bewirkt.

Die Polymerisation der Monomeren erfolgt in einem Temperaturbereich von 0 bis 500°C, vorzugsweise zwischen 20 bis 250°C. Dazu bringt man den behandelten und beschichteten Werkstoff in ein Gefäß, das z.B. mit Pyrroldampf gefüllt ist oder man sprüht das Pyrrol auf das Werkstück auf. Die Polymerisation kann bei beliebigen Drucken erfolgen. So arbeitet man zweckmäßig in einem Druckbereich zwischen 0,1 und 1000 bar.

Bei der Beschichtung des keramischen Werkstück durch elektrochemische Oxidation wird der keramische Werkstoff in eine Lösung eingetaucht, die das Monomere und gegebenenfalls ein Leitsalz enthält. Der Werkstoff wird als Anode geschaltet. Die Kathode kann aus einem Metall wie Platin, Edelstahl, Nickel oder Titan bestehen. Die Elektrolytlösung enthält ein Lösungsmittel, das as Monomere und das Leitsalz löst. Besonders geeignet für ihre anodische Oxidation sind polare organische Lösungsmittel wie Alkohole, Ether wie 1,2-Dimethoxiethan, Dioxan, Tetrahydrofuran, Aceton, Acetonitril, Dimethylformamid oder Propylencarbonat. Zweckmäßig arbeitet man mit 0,01 bis 1 Mol Monomeres pro Liter Lösungsmittel. Die Leitsalzkonzentration kann 0,001 bis 1, vorzugsweise 0,01 bis 0,1 Mol pro Liter Lösungsmittel betragen. Das Verfahren kann zweckmäßig in einer elektrolytischen Zelle mit externer Spannungsquelle durchgeführt werden. Die Reaktionstemperatur ist unkritisch. Sie liegt zweckmäßig zwischen -20 bis 80°C, vorzugsweise um Raumtemperatur. Zweckmäßig wird eine Spannung von 0,5 bis 3 Volt gewählt.

Die Monomeren werden bei Stromdichten von 0,1 bis 200 $mAp/m^2$ und Zeiten von 30 bis 300 Minuten polymerisiert.

Die Funktionskeramiken, die nach dem erfindungsgemäßen Verfahren hergestellt werden, sind als piezoelektrische Bauelemente: wie Sensoren, Aktoren, Schalter, Elektroden, Widerstände, Thyristoren, Transistoren, Mikrowellenfilter, dielektrische Resonatoren sowie Relais geeignet.

Beispiel 1

Die Oberfläche eines Piezokeramikplättchens (400 $\mu$ dick) wird mit einer 10 %igen ethanolischen Lösung von Eisenperchlorat bestrichen. Man läßt das Lösungsmittel abdampfen und setzt das so behandelte Material bei einer Temperatur von 150°C 30 Sekunden einer Stickstoffatmosphäre aus, die 10 Vol.% Pyrroldampf enthält. Innerhalb weniger Sekunden bildet sich an der Filmoberfläche eine schwarze Schicht aus. Dieser unlösliche Polypyrrolüberzug hat eine spezifische Leitfähigkeit von $10^{-1}$ S/cm.

## Beispiel 2

Es wird wie in Beispiel 1 gearbeitet, jedoch als keramischer Werkstoff eine Mehrschichtenplatte verwendet. Die spezifische Leitfähigkeit des ausgebildeten Polypyrrolfilms ist $10^{-1}$ S/cm.

## Beispiel 3

Es wird wie in Beispiel 1 gearbeitet, jedoch als keramischer Werkstoff ein poröses Bleizirkonat-titanat verwendet. Die spezifische Leitfähigkeit des Polypyrrolfilms beträgt $10^{-2}$ S/cm.

## Beispiel 4

Eine Piezokeramik einer Dicke von 300 $\mu$ wird mit einer wäßrigen Lösung bestrichen, die 10 % Natriumperoxidisulfat und 5 % Benzolsulfonsäure enthält. Das Wasser wird abgedampft und das so behandelte Material mit einer 10 %igen ethanolischen Pyrrollösung bestrichen. Es bildet sich eun unlöslicher festhaftender Film aus, der eine spezifische Leitfähigkeit von $0,2.10^{-1}$ S/cm hat.

## Beispiel 5

Es wird wie in Beispiel 1 beschrieben gearbeitet, jedoch wird eine Lösung die 10 Gew.% Eisenperchlorat und 10 Gew.% Polyvinylalkohol enthält, aufgebracht und das Wasser abgedampft. Nach dem Einwirken der Pyrrol-Atmosphäre wird ein Polypyrrolfilm erhalten, der fest auf dem Keramik-Werkstoff haftet. Die spezifische Leitfähigkeit beträgt $0,6\cdot10^{-2}$ S/cm.

## Beispiel 6

Es wird wie in Beispiel 4 beschrieben, gearbeitet, und das mit Peroxidisulfat und Benzolsulfonsäure behandelte Werkstück von 3 $\times$ 6 cm Fläche und 200 $\mu$ Dicke als Anode geschaltet und in eine Lösung von 1 g Pyrrol in 100 ml Acetonitril und 0,5 g Benzolsulfonsäure als Leitsalz enthält eingetausccht. Die Stromdichte beträgt 10 mAmpere/cm². Die Zeit beträgt 60 Minuten und der Elektrodenabstand 3 cm. Die Kathode ist ein Platinblech von 0,5 mm Dicke.

Nach der Polymerisationszeit ist ein schwarzer Polypyrrolüberzug auf dem Werkstoff entstanden, der eine Leitfähigkeit von $10^{-1}$ S/cm aufweist.

## Ansprüche

1. Verfahren zur Herstellung eines Verbundwerkstoffes aus einem elektrisch leitfähigen Polymeren und einem keramischen Werkstoff, dadurch gekennzeichnet, daß man auf die Oberfläche des keramischen Werkstoffes ein Monomeres aus der Klasse der fünfgliedrigen Heterocyclen, die Stickstoff oder Schwefel als Heteroatom enthalten, oder Anilin, aufbringt und durch chemische oder anodische Oxidation polymerisiert.

2. Verfahren nach Anspruch 1, dadurch gekennzeichnet, daß man die Polymerisation der Monomeren in Gegenwart eines Leitsalzes vornimmt.